# FASCICULE DE BREVET EUROPEEN

(11) **EP 0 554 143 B1**
(45) Date de publication et mention de la délivrance du brevet: **08.05.1996**
(21) Numéro de dépôt: 93400128.0
(22) Date de dépôt: 20.01.1993
(51) Int. Cl.: G01D 11/18, G01R 7/08, G01R 1/14

(54) **Actionneur électrique pivotant, notamment pour tableaux de bord de véhicules automobiles**
Schwenkbares, elektrisches Betätigungselement, insbesondere zum Gebrauch bei Kraftfahrzeugarmaturenbrettern
Pivoting electrical actuator, especially for use in vehicle dashboards

(30) Priorité: 20.01.1992 FR 9200536
(43) Date de publication de la demande: 04.08.1993
(73) Titulaire: JAEGER, F-92000 Nanterre Cédex (FR)
(72) Inventeur: Caizergues, Antoine, F-92290 Chatenay Malabry (FR); Mora, Jean-Louis, F-60270 Gouvieux (FR)
(74) Mandataire: Martin, Jean-Jacques

(56) Documents cités:
- DE-A- 3 500 879
- DE-A- 3 937 149
- PATENT ABSTRACTS OF JAPAN vol. 6, no. 125 (P-127)10 Juillet 1982 & JP-A-57 052 880 ( CITIZEN WATCH CO LTD ) 29 Mars 1982

## Description

La présente invention concerne le domaine des actionneurs électriques pivotants.

Dans le cadre de la présente demande de brevet, on entend par "actionneur électrique pivotant", un système comprenant un organe moteur à commande électrique comportant un arbre de sortie portant un élément utile, par exemple une aiguille indicatrice, et entraîné à pivotement autour de son axe selon un angle variable lié au signal électrique de commande.

La présente invention trouve notamment application dans les tableaux de bord de véhicules automobiles.

On a proposé en particulier de réaliser des actionneurs pour tableaux de bord de véhicules automobiles à l'aide de logomètres ou de moteurs pas à pas.

On rappelle que les logomètres sont des dispositifs comprenant plusieurs bobines croisées, soit de préférence deux bobines croisées à 90°, un arbre guidé à rotation, un aimant solidaire de l'arbre placé à l'intérieur des bobines, une aiguille indicatrice externe aux bobines et solidaire de l'arbre et des moyens de commande appliquant des signaux électriques appropriés aux bobines.

Le plus souvent les logomètres comprennent également une coupelle fixe contenant un liquide d'amortissement dans lequel baigne l'aimant.

Chacune des bobines génère un champ magnétique proportionnel au courant qui la traverse. L'aimant se positionne selon la résultante de ces champs. Pour un logomètre à deux bobines, l'angle défini par l'aiguille indicatrice, par rapport à une position d'origine, est donc déterminé par l'expression arctg I1/I2, dans laquelle I1 et I2 représentent une valeur proportionnelle aux ampères tours circulant respectivement dans les bobines.

De nos jours, les moteurs pas à pas sont également utilisés pour la réalisation d'actionneurs électriques.

Toutefois, les moteurs pas à pas ne donnent pas totalement satisfaction.

Ils n'ont pas naturellement de couple de rappel leur permettant de revenir à zéro. De plus, les moteurs pas à pas utilisés en boucle ouverte peuvent présenter des erreurs non négligeables par sauts accidentels de pas.

Pour palier ces inconvénients, il a été proposé d'associer les moteurs pas à pas à des systèmes de remise à zéro. Plus précisément, les systèmes de remise à zéro de moteur pas à pas jusqu'ici proposés dans le cadre d'application aux tableaux de bord de véhicules automobiles sont formés de systèmes électriques raccordés à une ligne d'alimentation du véhicule sous tension permanente, référencée généralement +PER.

Cette solution ne donne cependant pas totalement satisfaction. En particulier, on tend de nos jours à multiplier les accessoires alimentés par cette ligne sous tension permanente, alors que l'intensité totale autorisée sur cette ligne est limitée lorsque le véhicule est à l'arrêt.

Il a également été proposé d'associer un ressort spiral de rappel au moteur pas à pas. Cette solution ne donne pas non plus totalement satisfaction dans la mesure où elle conduit à un couple nul dans la position d'origine ou position de zéro du système.

Le document DE-A-3937149 décrit un actionneur électrique du genre logomètre comprenant un organe moteur à commande électrique comportant un arbre de sortie entraîné à pivotement autour de son axe selon un angle variable lié au signal électrique de commande, un élément utile formé d'une aiguille portée par l'arbre de sortie et un ressort spiral dont les extrémités sont fixées respectivement sur le boîtier de l'organe moteur et sur l'arbre de sortie. Cet actionneur comprend en outre un jeu de pignons dont un pignon possédant des butées pour limiter l'angle de rotation.

Le document DE-A-3500879 décrit un actionneur comprenant un arbre qui porte une aiguille et une came sollicitée par un élément ressort bimétal associé à un bobinage de chauffe à commande électrique.

La présente invention a pour but de perfectionner les actionneurs électriques pivotants antérieurs.

Ce but est atteint selon la présente invention grâce à un actionneur électrique pivotant du type défini en revendication 1 annexée.

Comme cela sera précisé par la suite, le système à cliquet conforme à la présente invention, permet d'armer le ressort, donc de définir un couple de rappel non nul en position de zéro de l'actionneur.

D'autres caractéristiques, buts et avantages de la présente invention apparaîtront à la lecture de la description détaillée qui va suivre et en regard du dessin unique annexé, donné à titre d'exemple non limitatif et qui représente une vue schématique en coupe axiale d'un actionneur électrique conforme à la présente invention.

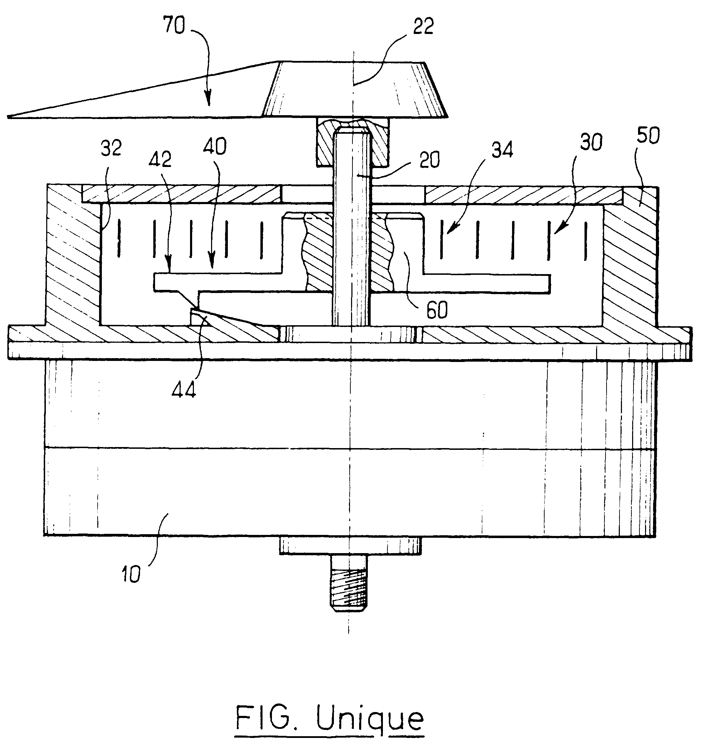

On a représenté sur la figure 1 sous la référence 10 le boîtier logeant un organe moteur à commande électrique, de préférence un moteur pas à pas.

L'organe moteur peut être formé de toute structure connue de l'homme de l'art. Pour cette raison, l'organe moteur intégré au boîtier 10 ne sera pas décrit par la suite.

Cet organe moteur possède un arbre 20 entraîné à pivotement autour de son axe 22 selon un angle lié au signal électrique appliqué à l'entrée de l'organe moteur.

Comme indiqué précédemment, dans le cadre de la présente invention, il est prévu un ressort spiral 30 et un système à cliquet 40 associé à l'organe moteur.

En l'espèce, le ressort spiral 30 et le système à cliquet 40 sont placés dans un boîtier 50 lié au boîtier 10 de l'organe moteur.

Le ressort spiral 30 est placé autour de l'arbre 20. Il possède une première extrémité 32, de préférence son extrémité radialement externe, liée au boîtier 50 et donc au boîtier 10 de l'organe moteur, et une seconde extrémité 34, de préférence son extrémité radialement interne, liée à l'arbre 20.

Plus précisément, la seconde extrémité 34 du ressort spiral 30 peut, soit être liée directement à l'arbre 20, soit être liée indirectement à celui-ci par l'intermédiaire d'une virole 60 elle-même fixée sur l'arbre 20.

Le système à cliquet 40 comprend, de façon connue en soi, un levier ou cliquet 42 associé à une roue dentée 44 de sorte que le mouvement relatif entre le levier 42 et la roue dentée 44 ne soit autorisé que dans un seul sens.

Selon le mode de réalisation représenté sur la figure annexée, le levier 42 est lié à la virole 60, c'est-à-dire à l'arbre 20, tandis que la roue dentée 44 est liée au boîtier 50.

La disposition inverse peut être retenue, c'est-à-dire que la roue dentée 44 pourrait être rendue solidaire de l'arbre 20, tandis que le levier 42 serait rendu solidaire du boîtier 50.

L'essentiel est que la coopération définie entre le levier 42 et la roue dentée 44 soit telle que le levier 42 vienne en appui contre une dent de la roue dentée 44 sous l'effet du rappel élastique défini par le ressort spiral 30, lorsque l'arbre 20 atteint la position d'origine souhaitée ou position de zéro de l'actionneur.

La roue dentée 44 peut comprendre une dent unique comme représenté sur la figure annexée. En variante, il peut être prévu une roue dentée 44 présentant plusieurs dents équi-réparties autour de l'axe 22 sous réserve que l'ouverture angulaire entre deux dents adjacentes soit au moins égale à l'angle utile de pivotement souhaité pour l'arbre 20.

De préférence dans le cas où la roue dentée 44 possède plusieurs dents équi-réparties autour de l'axe 22, il sera prévu un même nombre de dents, équi-réparties autour dudit axe 22, sur le cliquet 42.

On a représenté schématiquement sous la référence 70, une aiguille fixée sur l'une des extrémités de l'arbre 20.

Par ailleurs selon le mode de réalisation représenté sur la figure annexée, on notera que le boîtier 50 logeant le ressort spiral 30 et le système à cliquet 40 est placé entre l'organe moteur 10 et l'aiguille 70.

Cependant en variante, on peut prévoir de placer le boîtier 50 logeant le ressort spiral 30 et le système à cliquet 40 sur la face opposée de l'organe moteur 10, c'est-à-dire à l'opposé de l'aiguille 70 par rapport à cet organe moteur 10.

L'homme de l'art comprendra aisément que grâce au cliquet, pour contrôler la force de rappel du ressort spiral 30 en position zéro de l'actionneur, il suffit d'entraîner l'arbre de sortie 20 autour de son axe 22 sur une plage angulaire contrôlée dans laquelle le levier 42 franchit au moins une fois une dent de la roue dentée 44.

L'armage du ressort spiral 30 défini par le système à cliquet 40 doit être tel qu'en position zéro de l'actionneur, le couple de rappel du ressort 30 soit supérieur au couple de verrouillage de l'organe moteur hors tension.

Par ailleurs, on sait que le couple de rappel d'un ressort spiral croit sensiblement linéairement avec son angle de sollicitation. Pour limiter la dynamique de variation de ce couple de rappel, on prévoit de préférence un armage du ressort 30, grâce au système à cliquet 40, sur un nombre n de tours, avec n compris entre 1 et 3, par rapport à la position libre de repos du ressort.

A titre d'exemple non limitatif, on peut entraîner l'arbre de sortie 20 sur 720°, soit deux tours pour armer initialement le ressort spiral 30.

La présente invention trouve notamment application dans la réalisation d'actionneurs électriques pivotants à l'aide de moteurs pas à pas. Toutefois, elle n'est pas limitée à ce type particulier de réalisation et s'étend à l'utilisation de tout type d'organes moteurs électriques pour lequel le couple de rappel doit être non nul près de zéro.

Les moteurs pas à pas fonctionnent généralement selon des cycles de déplacement formés chacun d'une succession de positions stables dont le nombre dépend à la fois du nombre de bobinages stator du moteur, du nombre de poles du rotor et du mode de commande de ceux-ci.

Par ailleurs, il est généralement souhaitable, pour simplifier la commande du moteur pas à pas d'initier la commande de ceux-ci, à partir de la position zéro de l'actionneur à l'origine d'un cycle de déplacement. Pour cela, il est souhaitable lors de l'assemblage du système à cliquet de contrôler que la position zéro de l'actionneur, défini par la butée du cliquet 42 sur une dent de la roue dentée 44 corresponde effectivement à l'origine d'un cycle de déplacement. Dans le cas contraire, les premières impulsions appliquées au moteur pas à pas peuvent générer une erreur de positionnement.

## Revendications

1. Actionneur électrique pivotant du type comprenant un organe moteur (10) à commande électrique comportant un arbre de sortie (20) entraîné à pivotement autour de son axe (22), selon un angle variable lié au signal électrique de commande, un élément utile (70) porté par l'arbre de sortie (20), et un ressort spiral (30) dont les extrémités (32, 34) sont fixées respectivement sur le boîtier (10) de l'organe moteur et sur l'arbre de sortie (20), caractérisé par le fait qu'il comprend en outre un système à cliquet (40) monté entre le boîtier (10) de l'organe moteur et l'arbre de sortie (20), lequel système à cliquet (40) comprend un levier (42) associé à une roue dentée (44), l'un, du levier (42) ou de la roue dentée (44), étant solidaire de l'arbre de sortie (20), tandis que l'autre, du levier (42) ou de la roue dentée (44), est solidaire du boîtier (10) de l'organe moteur.

2. Actionneur selon la revendication 1, caractérisé par le fait que le levier (42) du système à cliquet (40) est solidaire de l'arbre de sortie (20), tandis que la roue dentée (44) du système à cliquet (40) est solidaire du boîtier (10) de l'organe moteur.

3. Actionneur selon l'une des revendications 1 à 2, caractérisé par le fait que le nombre de dents du levier (42) est égal au nombre de dents de la roue dentée (44).

4. Actionneur selon l'une des revendications 1 à 3, caractérisé par le fait que la roue dentée (44) comprend une dent unique.

5. Actionneur selon l'une des revendications 1 à 3, caractérisé par le fait que l'écart angulaire défini entre deux dents de la roue dentée (44) du système à cliquet est au moins égal à l'angle utile de pivotement de l'actionneur.

6. Actionneur selon l'une des revendications 1 à 5, caractérisé par le fait que l'organe moteur à commande électrique est un moteur pas à pas.

7. Actionneur selon l'une des revendications 1 à 6, caractérisé par le fait que le système à cliquet est adapté de sorte que le levier (42) vienne reposer contre une dent de la roue dentée (44) sous l'effet de la sollicitation du ressort spiral (30) lorsque l'arbre de sortie (20) est en position d'origine.

8. Actionneur selon l'une des revendications 1 à 7, caractérisé par le fait que l'élément utile est une aiguille indicatrice (70).

9. Actionneur selon l'une des revendications 1 à 8, caractérisé par le fait que le ressort spiral (30) et le système à cliquet (40) sont placés dans un boîtier (50) situé entre l'organe moteur (10) et l'élément utile (70).

10. Actionneur selon l'une des revendications 1 à 9, caractérisé par le fait que le ressort spiral (30) est armé à l'aide du système à cliquet (40) pour générer en position zéro de l'actionneur, un couple de rappel supérieur au couple de verrouillage hors tension de l'organe moteur.

11. Actionneur selon l'une des revendications 1 à 10, caractérisé par le fait que le ressort (30) est armé grâce au système à cliquet (40) d'un nombre de tours n compris entre 1 et 3.

12. Actionneur selon l'une des revendications 1 à 11, caractérisé par le fait que le système à cliquet (40) est positionné de sorte que la position zéro de l'actionneur coïncide avec l'origine d'un cycle de déplacement de l'organe moteur.

## Claims

1. A pivoting electrical actuator of the type comprising an electrically controlled drive member (10) having an output shaft (20) pivotally driven about its axis (22) through a variable angle associated with an electrical control signal, a working element (70) carried by the output shaft (20), and a spiral spring (30) whose ends (32, 34) are fixed respectively to the housing (10) of the drive member and to the output shaft (20), the actuator being characterized by the fact that it further comprises a ratchet system (40) mounted between the housing (10) of the drive member and the output shaft (20), which ratchet system (40) comprises a lever (42) associated with a toothed wheel (44), one of the lever (42) and the toothed wheel (44) being secured to the output shaft (20) while the other of the toothed wheel (44) and the lever (42) is secured to the housing (10) of the drive member.

2. An actuator according to claim 1, characterized by the fact that the lever (42) of the ratchet system (40) is secured to the output shaft (20) while the toothed wheel (44) of the ratchet system (40) is secured to the housing (10) of the drive member.

3. An actuator according to claim 1 or 2, characterized by the fact that the number of teeth of the lever (42) is equal to the number of teeth of the toothed wheel (44).

4. An actuator according to any one of claims 1 to 3, characterized by the fact that the toothed wheel (44) has a single tooth.

5. An actuator according to any one of claims 1 to 3, characterized by the fact that the angle between two teeth of the toothed wheel (44) of the ratchet system is at least as great as the working pivot angle of the actuator.

6. An actuator according to any one of claims 1 to 5, characterized by the fact that the electrically controlled drive member is a stepper motor.

7. An actuator according to any one of claims 1 to 6, characterized by the fact that the ratchet system is adapted so that the lever (42) rests against a tooth of the toothed wheel (44) under urging from the spiral spring (30) when the output shaft (20) is in its origin position.

8. An actuator according to any one of claims 1 to 7, characterized by the fact that the working element is an indicating pointer (70).

9. An actuator according to any one of claims 1 to 8, characterized by the fact that the spiral spring (30) and the ratchet system (40) are placed in a housing (50) situated between the drive member (10) and the working element (70).

10. An actuator according to any one of claims 1 to 9, characterized by the fact that the spiral spring (30) is cocked by the ratchet system (40) so that when the actuator is in a zero position the spring generates a return torque greater than the no-voltage locking torque of the drive member.

11. An actuator according to any one of claims 1 to 10, characterized by the fact that the spring (30) is cocked by the ratchet system (40) turning through n turns where n lies in the range 1 to 3.

12. An actuator according to any one of claims 1 to 11, characterized by the fact that the ratchet system (40) is positioned in such a manner that the zero position of the actuator coincides with the origin of a displacement cycle of the drive member.

## Patentansprüche

1. Elektrisches Drehbetätigungsgerät mit einem elektrisch angetriebenen Antriebsteil (10), der eine Ausgangswelle (20) aufweist, die um ihre Achse (22) um einen variablen Winkel gedreht wird, der zum elektrischen Antriebssignal in Beziehung steht, einem Nutzelement (70), das von der Ausgangswelle (20) gehalten ist, und einer Spiralfeder (30), deren Enden (32, 34) jeweils am Gehäuse (10) des Antriebsteils und an der Ausgangswelle (20) befestigt sind, dadurch gekennzeichnet, daß es weiterhin eine Klinkenanordnung (40) umfaßt, die zwischen dem Gehäuse (10) des Antriebsteils und der Ausgangswelle (20) angebracht ist, welche Klinkenanordnung (40) einen Hebel (42) umfaßt, der einem Zahnrad (44) zugeordnet ist, wobei entweder der Hebel (42) oder das Zahnrad (44) an der Ausgangswelle (20) befestigt ist, während das jeweils andere Bauteil, d.h. entweder der Hebel (42) oder das Zahnrad (44) am Gehäuse (10) des Antriebsteils befestigt ist.

2. Betätigungsgerät nach Anspruch 1, dadurch gekennzeichnet, daß der Hebel (42) der Klinkenanordnung (40) an der Ausgangswelle (20) befestigt ist, während das Zahnrad (44) der Klinkenanordnung (40) am Gehäuse (10) des Antriebsteils befestigt ist.

3. Betätigungsgerät nach einem der Ansprüche 1 bis 2, dadurch gekennzeichnet, daß die Anzahl der Zähne des Hebels (42) gleich der Anzahl der Zähne des Zahnrades (44) ist.

4. Betätigungsgerät nach einem der Ansprüche 1 bis 3, dadurch gekennzeichnet, daß das Zahnrad (44) einen einzigen Zahn aufweist.

5. Betätigungsgerät nach einem der Ansprüche 1 bis 3, dadurch gekennzeichnet, daß der Winkelabstand zwischen zwei Zähnen des Zahnrades (44) der Klinkenanordnung wenigstens gleich dem Nutzdrehwinkel des Betätigungsgerätes ist.

6. Betätigungsgerät nach einem der Ansprüche 1 bis 5, dadurch gekennzeichnet, daß der elektrisch angetriebene Antriebsteil ein Schrittmotor ist.

7. Betätigungsgerät nach einem der Ansprüche 1 bis 6, dadurch gekennzeichnet, daß die Klinkenanordnung so ausgebildet ist, daß der Hebel (42) an einem Zahn des Zahnrades (44) unter dem Einfluß der Vorspannung der Spiralfeder (30) zur Anlage kommt, wenn sich die Ausgangswelle (20) in ihrer Ausgangsposition befindet.

8. Betätigungsgerät nach einem der Ansprüche 1 bis 7, dadurch gekennzeichnet, daß das Nutzelement ein Zeiger (70) ist.

9. Betätigungsgerät nach einem der Ansprüche 1 bis 8, dadurch gekennzeichnet, daß die Spiralfeder (30) und die Klinkenanordnung (40) in einem Gehäuse (50) angeordnet sind, das zwischen dem Antriebsteil (10) und dem Nutzelement (70) liegt.

10. Betätigungsgerät nach einem der Ansprüche 1 bis 9, dadurch gekennzeichnet, daß die Spiralfeder (30) durch die Klinkenanordnung (40) gespannt wird, um in der Nullposition des Betätigungsgerätes ein Rückführdrehmoment zu erzeugen, das größer als das Mitnahmedrehmoment des Antriebsteils ohne Spannung ist.

11. Betätigungsgerät nach einem der Ansprüche 1 bis 10, dadurch gekennzeichnet, daß die Feder (30) durch die Klinkenanordnung (40) in einer Anzahl von Umdrehungen n zwischen 1 und 3 gespannt wird.

12. Betätigungsgerät nach einem der Ansprüche 1 bis 11, dadurch gekennzeichnet, daß die Klinkenanordnung (40) derart angeordnet ist, daß die Nullposition des Betätigungsgerätes mit dem Ausgangspunkt eines Versetzungszyklus des Antriebsteils zusammenfällt.
